(19) Europäisches Patentamt
European Patent Office
Office européen des brevets

(11) **EP 2 671 090 B1**

(12) **EUROPÄISCHE PATENTSCHRIFT**

(45) Veröffentlichungstag und Bekanntmachung des Hinweises auf die Patenterteilung:
**08.10.2014 Patentblatt 2014/41**

(21) Anmeldenummer: **11802687.1**

(22) Anmeldetag: **07.12.2011**

(51) Int Cl.:
***G01R 31/34*** *(2006.01)*

(86) Internationale Anmeldenummer:
**PCT/EP2011/072110**

(87) Internationale Veröffentlichungsnummer:
**WO 2012/103975 (09.08.2012 Gazette 2012/32)**

(54) **Verfahren und Vorrichtung zur Erkennung eines Fehlverhaltens einer Elektromaschine**

Method and device for detecting a malfunction of an electric machine

Procédé et dispositif pour détecter un dysfonctionnement d'une machine électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.02.2011 DE 102011003573**

(43) Veröffentlichungstag der Anmeldung:
**11.12.2013 Patentblatt 2013/50**

(73) Patentinhaber: **Robert Bosch GmbH
70442 Stuttgart (DE)**

(72) Erfinder: **FALKENSTEIN, Jens-Werner
73434 Aalen (DE)**

(56) Entgegenhaltungen:
**EP-A1- 2 226 929     US-A1- 2010 320 953**

## Beschreibung

Stand der Technik

Die Erfindung betrifft ein Verfahren zur Erkennung eines Fehlverhaltens einer Elektromaschine, bei welchem eine erste, das Drehmoment der Elektromaschine beeinflussende Größe moduliert wird sowie eine Vorrichtung zur Durchführung des Verfahrens.

Das Drehmoment einer Elektromaschine kann über mehrere unabhängige Größen beeinflusst werden. Geeignete Messsysteme zur direkten Ermittlung einer Momenten- oder Leistungsabgabe von Elektromaschinen sind in Kraftfahrzeugantriebsträngen normalerweise nicht vorhanden. Zum Beispiel wird aus Kostengründen auf die Messung eines Antriebs-Wellenmomentes verzichtet. Eine unerwünschte Momenten- oder Leistungsabgabe der Elektromaschine lässt sich daher nicht direkt ermitteln. Insbesondere bei Elektro- oder Hybridfahrzeugen kann auch bei stehendem Fahrzeug ein Kraftschluss zwischen einer Elektromaschine und den Antriebsrädern des Fahrzeuges vorliegen. Eine unerwünschte Momenten- oder Leistungsabgabe einer Elektromaschine, z.B. aufgrund eines Fehlers in der Datenkommunikation oder eines Bauteilefehlers, kann dann eine höchst sicherheitskritische Bewegung des Kraftfahrzeuges hervorrufen, die dem Fahrerwunsch widerspricht.

Bei Elektrofahrzeugen bzw. Hybridfahrzeugen werden hohe Elektromaschinenleistungen eingesetzt, im Fehlerfall können somit hohe unerwünschte Beschleunigungen oder Verzögerungen entstehen. Dies führt zu einer instabilen Fahrdynamik, wobei insbesondere bei hohen Verzögerungen dem Fahrer kaum eine Möglichkeit zur Gegenreaktion bleibt. Auch falls die Elektromaschine ein beitragsmäßig zu kleines Moment liefert, kann dies sicherheitskritische Fahrsituationen hervorrufen. Soll z.B. zur Rekuperation ein Teil des gesamten Bremsmomentes von der Elektromaschine übernommen werden, kann es vorkommen, dass diese ihren Anteil am Bremsmoment aber nicht umsetzt.

Aus der EP 1387459 A1 ist ein Verfahren zur Fehlererkennung bei einer Antriebseinrichtung bekannt, bei welchem die Antriebseinrichtung einen Mehrphasen-Elektromotor und einen dem Elektromotor nachgeschalteten Stromrichter aufweist, bei der der Stromrichter die Spannung an den einzelnen Phasen des Elektromotors steuert, wobei die Phasenströme in den Phasen des Elektromotors jeweils periodisch verlaufen. Zur Fehlererkennung des Elektromotors werden mehrere Phasenströme des Elektromotors gemessen. Dabei erfolgt eine sinusförmige Modulation der Spannungen der Elektromaschine.

US 2010/320953 A1 und EP 2 226 929 A1 offenbaren verschiedene Systeme zum Überwachen von Elektromotoren.

Sicherheits- und Überwachungsgründe erfordern somit die genaue Kenntnis über die korrekte Momenten- oder Leistungsabgabe des Elektromotors und eine Möglichkeit zum schnellen und wirkungsvollen Eingriff im Fehlerfall.

Offenbarung der Erfindung

Bei einem Verfahren zur Erkennung eines Fehlerverhaltens einer Elektromaschine gemäß den Merkmalen des Patentanspruchs 1 wird die Fehlfunktion einer Elektromaschine detektiert und eine damit verbundene unerwünschte Momenten- oder Leistungsabgabe der Elektromaschine verhindert. Dadurch, dass eine zweite, das Drehmoment der Elektromaschine beeinflussende Größe moduliert wird, wobei sich die beiden, das Drehmoment beeinflussenden Größen in ihrer Wirkung auf einen Parameter der Elektromaschine, insbesondere ein Drehmoment, eine Drehzahl, einen elektrischen Parameter und/oder einen magnetischen Parameter, im fehlerfreien Betrieb kompensieren, während bei einer Nichtkompensation auf einen Fehlerfall geschlossen wird, lassen sich unter der Verwendung der elektrischen Größen Aussagen über das Verhalten des mechanischen Drehmomentes der Elektromaschine zuverlässig treffen.

Dabei ist unter der Modulation einer das Drehmoment der Elektromaschine beeinflussenden Größe eine Veränderung, insbesondere eine Überlagerung dieser Größe mit einem Testsignal, zu verstehen. Ein solches Testsignal kann dabei insbesondere über der Zeit und in seiner Form (z. B. Rechteck, (Sinus-)Schwingung, Sägezahn, Trapez) veränderlich sein.

Vorteilhafterweise ist die erste, das Drehmoment beeinflussende Größe einem Stator der Elektromaschine zugeordnet, während die zweite, das Drehmoment beeinflussende Größe einem Rotor der Elektromaschine zugeordnet ist. Dadurch werden zwei physikalisch unterschiedliche Größen, die das mechanische Drehmoment des Elektromotors beeinflussen, zur Erkennung eines Fehlverhaltens der Elektromaschine variiert. Nur bei einem fehlerfreien Betrieb der Elektromaschine führt die Variation dieser beiden physikalisch unterschiedlichen Größen zu einer Kompensation in ihrer Wirkung auf einen Parameter der Elektromaschine, insbesondere das Drehmoment, die Drehzahl, einen elektrischen Parameter und/oder einen magnetischen Parameter.

In einer Ausgestaltung ist die dem Stator zugeordnete Größe ein Statorstrom, während die dem Rotor zugeordnete Größe ein Rotorfluss ist. Somit werden zur Prüfung des Fehlverhaltens der Elektromaschinen nur die, unmittelbar auf die Funktion der Elektromaschine einwirkenden physikalischen Größen beeinflusst.

In einer Weiterbildung erfolgt die Modulation der ersten und der zweiten, das Drehmoment der Elektromaschine beeinflussenden Größe, indem auf das Grundsignal der jeweiligen Größe je ein Testsignal aufmoduliert wird. Diese verschiedenen Testsignale sind notwendig, da der Statorstrom bzw. der Rotorfluss zwei physikalisch unterschiedliche Größen darstellen, die physikalisch unterschiedliche oder unterschiedlich skalierte Testsignale erfordern. Testsignale sind beispielsweise ein, dem Statorstrom aufmodulierter Anteil und ein, dem den Rotorfluss bildenden Erregerstrom aufmodulierter Anteil.

In einer Variante wird bei der Aufmodulierung des Testsignals auf das Grundsignal eine Signalbegrenzung berücksichtigt, wobei das Testsignal so gewählt wird, dass nach der Aufmodulierung das modulierte Grundsignal die Signalbegrenzung nicht überschreitet. Somit wird gewährleistet, dass auch nach der Modulierung ein moduliertes Grundsignal vorhanden ist, welches vollständig zur Prüfung des Fehlverhaltens der Elektromaschine genutzt werden kann, da die Signalbegrenzung von Grundsignal und Testsignal zusammen nicht überschritten wird. Eine Überschreitung der Signalbegrenzung durch das modulierte Grundsignal würde eine Verzerrung des modulierten Grundsignals bei der elektronischen Verarbeitung nach sich ziehen, so dass die Testergebnisse nicht aussagekräftig sind. Bei der Modulation der einen, das Drehmoment der Elektromaschine beeinflussenden Größe ist auch die Signalbegrenzung der anderen, das Drehmoment der Elektromaschine beeinflussenden Größe zu beachten, damit die Kompensation der beiden Größen in ihrer Wirkung auf einen Parameter der Elektromaschine im fehlerfreien Betrieb sichergestellt ist. Alternativ werden Signalbegrenzungen zugelassen, wobei die Testsignale der beiden, das Drehmoment der Elektromaschine beeinflussenden Größen so aufeinander abgestimmt sind, dass auch bei aktiven Signalbegrenzungen die Kompensation im fehlerfreien Betrieb der Elektromaschine sichergestellt ist.

Vorteilhafterweise besteht mindestens ein Testsignal aus einer Schwingung. Die Verwendung einer Schwingung als Testsignal hat den Vorteil, dass sich ein solches Testsignal gut an die Betriebsweise der Elektromaschine anpasst. Vorzugsweise ist die Schwingung so gewählt, dass im Fehlerfall der Elektromaschine das Drehmoment der Elektromaschine im zeitlichen Mittel nicht geändert wird. Dadurch wird eine zusätzliche Beschleunigung oder Verzögerung des Fahrzeuges durch das Testsignal vermieden, indem die Frequenz der Schwingung hoch genug gewählt wird, beispielsweise, mit ca. 5 Schwingungsperioden pro Sekunde.

In einer Ausführungsform werden die Testsignale kontinuierlich auf die erste und die zweite, das Drehmoment der Elektromaschine beeinflussenden Größe aufmoduliert. Durch diese kontinuierliche Vorgehensweise wird die Elektromaschine ständig auf ein Fehlverhalten überprüft, wodurch kritische Zustände der Elektromaschine unmittelbar detektiert werden. Somit wird eine unmittelbare Reaktion auf ein detektiertes Fehlverhalten möglich.

In einer Alternative werden die Testsignale in mindestens einem definierten Betriebszustand der Elektromaschine auf die erste und die zweite, das Drehmoment der Elektromaschine beeinflussenden Größen aufmoduliert. So wird die Prüfung des Fehlverhaltens beispielsweise in einem Betriebszustand der Elektromaschine eingestellt, bei welchen hohe Beschleunigungen oder Verzögerungen auftreten, wie beispielsweise beim Rekuperationsbetrieb der Elektromaschine. Somit können insbesondere sicherheitskritische Fahrsituationen zuverlässig überwacht werden.

In einer besonders einfachen Weiterbildung werden die erste und die zweite, das Drehmoment der Elektromaschine beeinflussende Größe mit Testsignalen moduliert, welche ein entgegengesetztes Vorzeichen aufweisen, wodurch sich die Modulation des ersten und des zweiten, das Drehmoment der Elektromaschine beeinflussenden Größe im fehlerfreien Betrieb der Elektromaschine in ihrer Wirkung auf den Parameter der Elektromaschine, insbesondere die Drehzahl, das Drehmoment, den elektrischen Parameter und/oder den magnetischen Parameter, kompensieren, während der Fehlerfall anhand einer nicht kompensierenden Wirkung auf den Parameter der Elektromaschine, insbesondere das Drehmoment, die Drehzahl, den elektrischen Parameter und/oder den magnetischen Parameter, erkannt wird. Die Verwendung von Testsignalen mit entgegengesetzten Vorzeichen ermöglicht eine besonders einfache Erkennung der Funktionsweise bzw. des Fehlverhaltens der Elektromaschine.

Zur Feststellung, ob eine Kompensation oder eine Nichtkompensation der Wirkung der beiden modulierten, das Drehmoment der Elektromaschine beeinflussenden Größen vorhanden ist, gibt es verschiedene Auswertemöglichkeiten. So werden nach der Modulation der ersten und der zweiten, das Drehmoment der Elektromaschine beeinflussenden Größe ein Ist-Parameter der Elektromaschine gemessen, wobei auf einen fehlerfreien Betrieb der Elektromaschine erkannt wird, wenn dieser Ist-Parameter innerhalb eines Bereiches liegt, welcher um einen vorgegebenen zeitlichen Verlauf eines vorgegebenen Parameters aufgespannt ist. Damit wird eine gewisse Schwankungsbreite des Ist-Parameters der Elektromaschine in Abweichung zum erwarteten Soll-Parameter zugelassen und trotzdem ein fehlerfreier Betrieb der Elektromaschine erkannt.

In einer Ausgestaltung wird nach der Modulation der den Rotor der Elektromaschine beeinflussenden Größe ein sich am Stator der Elektromaschine einstellender erster Ist-Parameter gemessen, welcher mit dem Bereich verglichen wird, der um den vorgegebenen zeitlichen Verlauf des vorgegebenen ersten Parameters aufgespannt ist.

Alternativ wird nach der Modulation der den Stator der Elektromaschine beeinflussenden Größe ein sich am Rotor der Elektromaschine einstellender zweiter Ist-Parameter gemessen, welcher mit dem Bereich verglichen wird, der um den vorgegebenen zeitlichen Verlauf des erwarteten zweiten Parameters aufgespannt ist. Dabei werden elektrische Parameter, die aufgrund der Modulation der, das Drehmoment der Elektromaschine beeinflussenden Größe verändert wurden bzw. beeinflusst wurden, ausgewertet.

In einer weiteren Vorgehensweise werden mechanische Veränderungen an der Elektromaschine ausgewertet, indem nach der Modulation der ersten und der zweiten, das Drehmoment der Elektromaschine beeinflussenden Größe eine, an einem Antriebsstrang des Kraftfahrzeuges auftretende Drehschwingung gemessen wird und mit einem Bereich verglichen wird, der um den vorgegebenen zeitlichen Verlauf einer vorgegebenen Drehschwingung aufgespannt ist. Bei Modulation mit einem schwingungsförmigen Testsignal werden im Fehlerfall Drehschwingungen im Antriebsstrang angeregt. Aufgrund des meist linearen Schwingungsverhaltens eines Antriebsstranges des Kraftfahrzeuges weisen die Drehschwingungen dieselbe Frequenz auf wie das Testsignal. Entsprechende Drehschwingungen lassen sich anhand von Drehzahlsignalen, z.B. durch Korrelationsrechnungen, ermitteln. Ein Fehlerfall wird dann detektiert, wenn die Drehschwingungsamplituden eine vorgegebene Schwelle überschreiten.

Eine andere Möglichkeit der Auswertung des Fehlverhaltens der Elektromaschine besteht darin, dass nach der Modulation der ersten und der zweiten, das Drehmoment der Elektromaschine beeinflussenden Größe eine von der Elektromaschine abgegebene Drehzahl gemessen wird und mit einem Bereich verglichen wird, der um den vorgegebenen zeitlichen Verlauf einer vorgegebenen Drehzahl aufgespannt ist. Auch in diesem Fall wird ein Fehlverhalten der Elektromaschine anhand einer mechanisch auftretenden Veränderung der Elektromaschine detektiert.

In einer Ausgestaltung erfolgt die Überwachung der Drehschwingung, der Drehzahl, des ersten Ist-Parameters und/oder des zweiten Ist-Parameters der Elektromaschine getrennt voneinander in jeweils einem Überwachungspfad. Somit stehen mehrere unterschiedliche Methoden zur Detektion der Fehlfunktion der Elektromaschine zur Verfügung, die auf verschiedenen, voneinander unabhängigen Sensoren basieren. Dadurch wird eine hohe Redundanz bei der Überprüfung des Betriebsverhaltens der Elektromaschine erreicht.

In einer weiteren Ausführungsform werden zur Überwachung des Fehlverhaltens der Elektromaschine mindestens zwei unabhängige Überwachungspfade aktiviert. Da jeder Überwachungspfad ein anderes Auswerteverfahren zur Bestimmung des Fehlverhaltens der Elektromaschine aufweist, ist schon bei der Verwendung von nur zwei Überwachungspfaden eine ausreichende Redundanz gegeben. Auf ein Fehlverhalten der Elektromaschine wird geschlossen, sobald einer der Überwachungspfade ein Fehlverhalten der Elektromaschine anzeigt. Es liegt auch dann eine hohe Sicherheit vor, wenn einer der beiden Überwachungspfade defekt ist. Alternativ dazu wird ein Fehlverhalten der Elektromaschine nur in dem Fall anerkannt, wenn zwei Überwachungspfade unabhängig voneinander zu dem Ergebnis führen, dass ein Fehlverhalten der Elektromaschine vorliegt. Damit wird die Verfügbarkeit des Fahrzeugs erhöht.

Vorteilhafterweise führen die Überwachungspfade auf mindestens einen gemeinsamen Abschaltpfad der Elektromaschine und/oder einen gemeinsamen Pfad zur Beeinflussung der Funktionsweise der Elektromaschine. Somit wird sichergestellt, dass bei der Feststellung, dass eine Fehlfunktion der Elektromaschine vorliegt, die Elektromaschine sofort abgeschaltet wird. Ist dieses aber im Betrieb des Kraftfahrzeuges nicht möglich, wird die Funktionsweise der Elektromaschine dahingehend beeinflusst, dass die betreffenden Fehlerzustände korrigiert werden. Somit ist eine gestufte Vorgehensweise möglich, z.B. indem die Leistung der Elektromaschine eingeschränkt wird, falls einer der Überwachungspfade ein Fehlverhalten der Elektromaschine anzeigt. Zeigen zwei der Überwachungspfade ein Fehlverhalten an, erfolgt eine vollständige Abschaltung der Elektromaschine.

In einer Alternative führt jeder der Überwachungspfade auf mindestens einen Abschaltpfad der Elektromaschine und/oder einen Pfad zur Beeinflussung der Funktionsweise der Elektromaschine. Damit wird gewährleistet, dass, wenn nur durch einen Überwachungspfad eine Fehlfunktion der Elektromaschine festgestellt wurde, die Elektromaschine abgeschaltet oder in ihrer Funktionsweise beeinflusst wird. Wenn einer der Abschaltpfade defekt ist oder nicht korrekt arbeitet, schaltet ein weiterer Abschaltpfad die Elektromaschine bei einer Fehlfunktion ab oder gibt ein Signal an den Pfad zur Beeinflussung der Funktionsweise der Elektromaschine.

Eine weitere Weiterbildung der Erfindung betrifft eine Vorrichtung zur Erkennung eines Fehlverhaltens einer Elektromaschine, bei welchem eine erste, das Drehmoment der Elektromaschine beeinflussende Größe moduliert wird. Um eine Fehlfunktion einer Elektromaschine zu detektieren und eine damit verbundene unerwünschte Momenten- oder Leistungsabgabe zu verhindern, sind Mittel vorhanden, welche eine zweite, das Drehmoment der Elektromaschine beeinflussende Größe modulieren, wobei sich die beiden, das Drehmoment beeinflussenden Größen in ihrer Wirkung auf einen Parameter der Elektromaschine, insbesondere ein Drehmoment, eine Drehzahl, einen elektrischen Parameter und/oder einen magnetischen Parameter im fehlerfreien Betrieb kompensieren, während bei einer Nichtkompensation auf einen Fehlerfall geschlossen wird. Dies hat den Vorteil, dass durch Variation der elektrischen Parameter, die das Verhalten der Elektromaschine beeinflussen, Schlussfolgerungen auf die mechanische Betriebsweise der Elektromaschine gezogen werden können. Dadurch lässt sich eine sehr einfache Überwachungsanordnung realisieren.

In einer Ausgestaltung weist eine, eine Drehschwingung oder eine Drehzahl oder einen Parameter eines Stators der Elektromaschine oder einen Parameter eines Rotors der Elektromaschine detektierende Überwachungseinheit nur einen Überwachungspfad auf, an welchen sich ein Abschaltpfad der Elektromaschine und/oder ein Pfad zur Beeinflussung der Elektromaschine anschließt. Dadurch, dass jeweils nur ein Überwachungspfad zur Überwachung des Fehlverhaltens der Elektromaschine in einer Vorrichtung, beispielsweise einem Steuergerät, ausgebildet ist, ergibt sich eine hohe Redundanz bei der Überwachung des Betriebes der Elektromaschine, was hohen Sicherheitsanforderungen genügt.

Neben der Überwachung eines Fehlverhaltens der Elektromaschine, kann die Modulation mittels eines Testsignals auch zur Kalibrierung und/oder Überprüfung von Gebern und/oder zur sensorlosen Regelung der Elektromaschine und/oder für einen Notbetrieb der Elektromaschine bei einem Ausfall eines Sensors eingesetzt werden.

Die Erfindung lässt zahlreiche Ausführungsformen zu. Eine davon soll anhand der in der Zeichnung dargestellten Figuren näher erläutert werden.

Es zeigt:

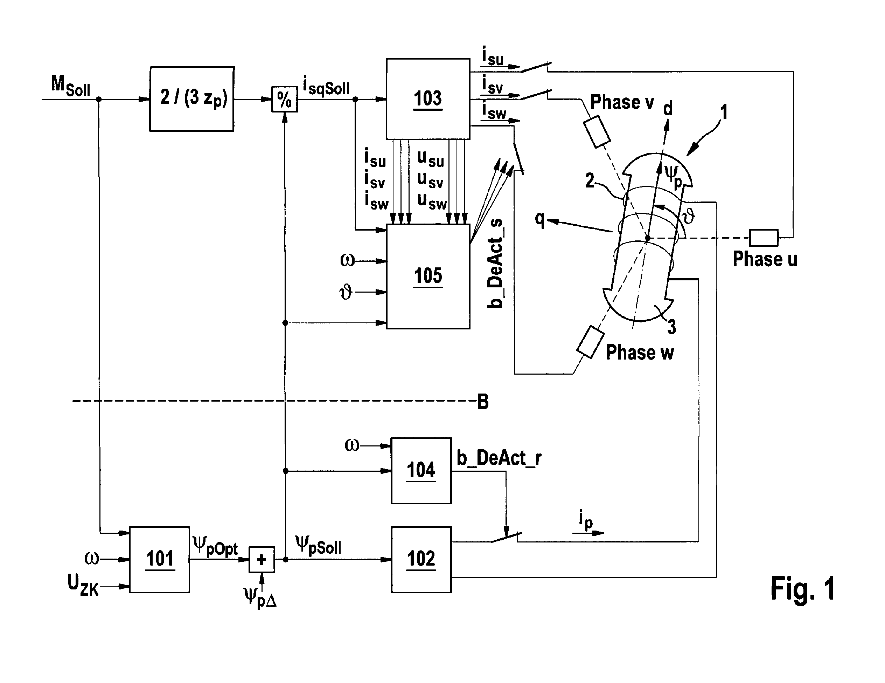

Figur 1: eine Prinzipdarstellung zur Ansteuerung einer Elektromaschine.

Figur 1 zeigt ein Ausführungsbeispiel für die vorliegende Erfindung am Beispiel einer fremderregten Drehstrom-Synchronmaschine 1, die zum Antrieb eines Elektrofahrzeugs eingesetzt wird. Die Wicklungen des nicht weiter dargestellten Stators sind als Phase u, Phase v und Phase w bezeichnet und stark vereinfacht dargestellt. Die Spulenachsen dieser Wicklungen sind jeweils um 120 Grad gegeneinander gedreht. Eine stromdurchflossene Erregerwicklung 2 im Rotor 3 erzeugt einen Rotorfluss $\psi_p$. Ein Fahrer des Kraftfahrzeuges bzw. ein Fahrerassistenzsystem oder ein Sicherheitssystem des Kraftfahrzeuges geben ein Solldrehmoment $M_{Soll}$ vor. Das Solldrehmoment $M_{Soll}$ wird während Schaltvorgängen eines automatisierten Getriebes von diesem beeinflusst.

Eine feldorientierte Betrachtungsweise einer Drehstrommaschine 1 beruht auf dem Prinzip der Raumzeiger. Der Zusammenhänge lassen sich vereinfachen, wenn man ein orthonormales, synchron mit den Raumzeigern umlaufendes d-q-Koordinatensystem betrachtet, dessen d-Achse mit der Richtung des Rotorflussraumzeigers $\psi_r$ bei einer Asynchronmaschine bzw. des Polradflussraumzeigers $\psi_p$ bei einer Synchronmaschine zusammenfällt. Die Raumzeiger lassen sich dann in d- und q-Komponenten zerlegen. Dabei verschwinden die q-Komponenten des Rotorflussraumzeigers bzw. Polradflussraumzeigers:

$$\psi_{rq} = 0$$
$$\psi_{pq} = 0$$

Bei der Synchronmaschine mit idealem Vollpolläufer ist das erzeugte Ist-Drehmoment M (Luftspaltdrehmoment) proportional zur q-Komponente $i_{sq}$ des Statorstromes:

$$M = 3/2 \ z_p \ \psi_p \ i_{sq}, \hspace{3cm} (1)$$

mit:

$Z_p$          Polpaarzahl

$\psi_p = \psi_{pd}$     Rotor- bzw- Polradfluss (d-Komponente)

Bei der fremderregten Synchronmaschine wird der Rotorfluss $\psi_p$ durch Vorgabe eines Erregerstromes $i_p$ eingestellt.

Im Block 101 wird anhand dieses Solldrehmomentes $M_{Soll}$, der Rotordrehzahl w und der aktuell verfügbaren Zwischenkreisspannung $U_{ZK}$ ein wirkungsgradoptimierter Rotorfluss $\psi_{pOpt}$ bei betragsmäßig geringem Solldrehmoment $M_{Soll}$ oder sehr hohen Rotordrehzahlen w zurückgenommen. Die Änderungsdynamik des Rotorflusses $\psi_p$ ist meist begrenzt, daher können noch Randbedingungen wie beispielsweise eine Drehmomentenreserve berücksichtigt werden.

Auf den optimalen Rotorfluss $\psi_{pOpt}$ wird ein Testsignal $\psi_{p\Delta}$ addiert bzw. aufmoduliert. Das Testsignal $\psi_{p\Delta}$ ist so gewählt, dass das Solldrehmoment $M_{Soll}$ bei günstigem Wirkungsgrad weiterhin erzeugt werden kann und auch der so berechnete Rotorfluss-Sollwert $\psi_{pSoll}$ einstellbar ist. Das Testsignal $\psi_{p\Delta}$ besteht dabei aus einer mittelwertsfreien Schwingung, die dauerhaft anliegt. Eine vom Betriebspunkt der Synchronmaschine 1 bzw. des Fahrzeuges abhängige Aktivierung und Modifikation des Testsignales $\psi_{p\Delta}$ ist ebenfalls möglich.

Der Rotorfluss-Sollwert $\psi_{pSoll}$ wird an einen Block 102 weitergeleitet. In diesem Block 102 wird der Strom $i_p$ an die Erregerwicklung 2 des Rotors 3 so vorgegeben bzw. durch Vorgabe einer Erregerspannung geregelt, dass sich der Rotorfluss-Istwert $\psi_p$ dem Rotorfluss-Sollwert $\psi_{pSoll}$ entsprechend einstellt. Ein Drehübertrager, der den Erregerstrom $i_p$ auf den rotierenden Rotor 3 überträgt, ist in Figur 1 der Einfachheit halber nicht dargestellt.

Das Solldrehmoment $M_{Soll}$ wird mit dem konstanten Faktor $2 / (3 \ z_p)$ multipliziert, wobei das Ergebnis durch den Rotorfluss-Sollwert ($\psi_{pSoll}$ dividiert wird. So ergibt sich ein Sollwert $i_{sqSoll}$ für die q-Komponente $i_{sq}$ des Statorstromes. Im Block 103 werden die Phasenspannungen $U_{SU}$, $U_{SV}$, $U_{SW}$ und damit die Phasenströme $i_{su}$, $i_{sv}$, $i_{sw}$ so eingestellt, dass die q-Komponente $i_{sq}$ des Statorstromes dem Sollwert $i_{sqSoll}$ folgt. Neben der Rotation des Rotors 3 führt auch die Modulation des Rotorflusses $\psi_p$ zu Induktionsspannungen im Stator der Elektromaschine 1. Eine nicht weiter dargestellte Berücksichtigung des Rotorfluss-Sollwertes $\psi_{pSoll}$ zusätzlich zur Rotordrehzahl $\omega$ verbessert die Stromregelung des Stators im Sinne einer Vorsteuerung.

Entsprechen der Rotorfluss-Istwert $\psi_p$, dem Rotorfluss-Sollwert $\psi_{pSoll}$ und der Statorstrom-Istwert $i_{sq}$ den Statorstrom-Sollwert $i_{sqSoll}$ so wird ein Ist-Drehmoment M erzeugt, das dem Solldrehmoment $M_{Soll}$ entspricht. Das heißt, dass die beiden das Drehmoment beeinflussenden Größen, der Rotorfluss $\psi_p$ und die q-Komponente des Statorstromes $i_{sq}$ bzw. die Phasenströme $i_{su}$, $i_{sv}$, $i_{sw}$ so moduliert werden, dass die Modulationen sich im fehlerfreien Betrieb der Elektromaschine in ihrer Wirkung auf das erzeugte Ist- Drehmoment M entsprechend Gleichung 1 kompensieren.

Die Istwerte folgen den Sollwerten meist nur verzögert, was beispielsweise durch Induktivitäten der Wicklungen und Zeitverzögerungen in den Signalübertragungen bedingt ist. Die Verzögerungen sind bekannt. Daher empfiehlt sich eine dynamische Korrektur bzw. Vorsteuerung der Sollwerte (Rotorfluss-Sollwert $\psi_{pSoll}$ und Statorstrom-Sollwert $i_{sqSoll}$), so dass sich die Modulationen der Istwerte $\psi_p$, $i_{sq}$ in ihrer Wirkung auf das erzeugte Drehmoment M kompensieren.

Gelangt der Rotorfluss $\psi_p$ infolge der Modulation mit dem Testsignal $\psi_{p\Delta}$ an eine Stellgrenze, beispielsweise weil der Erregerstrom $i_p$ eine Maximalgrenze erreicht, so wird dies in der Modulation des Statorstroms $i_{sq}$ berücksichtigt, so dass die Modulationen sich in ihrer Wirkung auf das erzeugte Drehmoment M im fehlerfreien Betrieb der Elektromaschine 1 weiterhin kompensieren. Entsprechend wird auch eine Stellgrößenbegrenzung des modulierten Statorstromes $i_{sq}$ bei der Vorgabe des Rotorflusses $\psi_p$ bzw. des Erregerstroms $i_p$ berücksichtigt.

Ein Fehler in der Datenkommunikation, ein Softwarefehler oder ein Bauteilfehler, in einem Steuergerät, einem Sensor oder einem Aktor, welcher das erzeugte Drehmoment M beeinflusst, wird auch die Modulationen des Rotorflusses $\psi_p$ und/oder des Statorstromes $i_{sq}$ beeinflussen. Entspricht z.B. aufgrund eines Speicherfehlers im Block 102 oder aufgrund eines Kurzschlusses zur Versorgungsspannung der Erregerstrom $i_p$ nicht mehr seinem Sollwert, so wird auch die Modulation im Erregerstrom $i_p$ und somit im Rotorfluss $\psi_p$ nicht mehr enthalten sein. Die verbleibende Modulation im Statorstrom $i_{sq}$ führt dann zu einer Modulation im erzeugten Drehmoment M.

Bei einem fehlerhaften Betrieb der Elektromaschine 1 heben sich die Modulationen im Rotorfluss $\psi_p$ und im Statorstrom $i_{sq}$ in ihrer Wirkung auf das erzeugte Drehmoment M nicht mehr auf, was bei schwingungsförmigem Testsignal $\psi_{p\Delta}$ zu überlagerten Schwingungen im erzeugten Drehmoment M und damit zu Drehschwingungen im Antriebsstrang führt. Eine erste Überwachungseinheit im Block 104, welche den Rotor 3 überwacht, erhält die gemessene Rotordrehzahl w und den modulierten Rotorfluss-Sollwert $\psi_{pSoll}$. Werden beispielsweise mittels Korrelationsrechnungen vorhandene Drehschwingungen im Antriebsstrang detektiert, die ihre Ursache in dem schwingungsförmigen Testsignal $\psi_{p\Delta}$ haben, so erfolgt eine Abschaltung des Erregerstromes $i_p$ und damit eine Abschaltung der Elektromaschine 1 durch das Signal b_DeAct_r. Alternativ zu einer Abschaltung sind Maßnahmen zu einer Korrektur eines fehlerhaften Drehmomentes M möglich, beispielsweise durch eine Korrektur des Statorstromes $i_{sq}$.

Die Modulation des Rotorflusses $\psi_p$ beeinflusst magnetische und elektrische Größen im Stator, während die Modulation des Statorstromes $i_{sq}$ magnetische und elektrische Größen im Rotor 3 beeinflusst. Anhand dieser Wirkmechanismen lässt sich ein fehlerhafter Betrieb der Elektromaschine 1 ebenfalls nachweisen. Beispielsweise führt neben der Rotation des Rotors 3 auch die Modulation des Rotorflusses $\psi_p$ zu Induktionsspannungen im Stator der Elektromaschine 1. Diese Induktionsspannungen werden bei der Stromregelung des Stators, d.h. bei der Vorgabe der Phasenspannungen $U_{su}$, $U_{sv}$, $U_{sw}$ berücksichtigt bzw. kompensiert, sodass sich die vorgegebenen Phasenströme $i_{su}$, $i_{sv}$, $i_{sw}$ einstellen. Diese werden so vorgegeben, dass die q-Komponente $i_{sq}$ des Statorstromes dem ebenfalls modulierten Sollwert $i_{sqSoll}$ folgt.

Im Block 105 ist eine zweite Überwachungseinheit dargestellt, die Phasenspannungen $u_{su}$, $u_{sv}$, $u_{sw}$ und die gemessenen Phasenströme $i_{su}$, $i_{sv}$, $i_{sw}$ als Eingangsgrößen übernimmt. Weiterhin wird dem Block 105 zur Überwachung des Stators der Rotorfluss-Sollwert $\psi_{pSoll}$ und die gemessene oder beobachtete Rotordrehzahl w sowie der gemessene oder beobachtete Rotordrehwinkel $\vartheta$ zugeführt. Im Block 105 wird zur Überwachung des Stators geprüft, ob die magnetischen und elektrischen Größen im Stator zum modulierten Rotorfluss-Sollwert $\psi_{pSoll}$ plausibel sind. Dies kann z.B. erfolgen, indem modellierte, d.h. anhand eines mathematischen Modells bestimmte Werte der Phasenströme $i_{SUMod}$, $i_{SVMod}$, $i_{SWMod}$ mit den gemessenen Phasenströmen $i_{su}$, $i_{sv}$, $i_{sw}$ verglichen werden. Das mathematische Modell berücksichtigt auch die zusätzlichen Induktionsspannungen im Stator, die aufgrund der Modulation des Rotorflusses $\psi_p$ im fehlerfreien Betrieb entstehen. Ändert sich die Modulation des Rotorflusses $\psi_p$ im Fehlerfall der Elektromaschine 1, so führt dies zu Abweichungen der gemessenen von den modellierten Phasenströmen. Bei zu großen Abweichungen sperrt der Block 105 mit dem Signal b_DeAct_s die Phasenströme und schaltet die Elektromaschine 1 ab. Ein fehlerfreier Betrieb der Elektromaschine wird erkannt, wenn die einzelnen gemessenen Phasenströme $i_{su}$, $i_{sv}$, $i_{sw}$ innerhalb von Bereichen liegen, welche um die vorgegebenen zeitlichen Verläufe der modellierten Phasenströme $i_{suMod}$, $i_{svMod}$, $i_{swMod}$ liegen. Diese Methode greift insbesondere bei kleinen Rotordrehzahlen, bei denen andere Methoden, wie z.B. eine Leistungsbilanz nur bedingt einsetzbar sind.

Falls beobachtete Größen für die Rotordrehzahl w und den Rotordrehwinkel 9 benutzt werden, wird im Block 105 nur auf die gemessenen Phasenströme $i_{su}$, $i_{sv}$, $i_{sw}$ zurückgegriffen. Im Block 104 zur Überwachung des Rotors 3 wird nur die gemessene Rotordrehzahl w genutzt. Die durch die Blöcke 104 und 105 gebildeten Überwachungseinheiten nutzen voneinander unabhängig Sensoren und greifen über voneinander unabhängige Abschaltpfade ein, was eine hohe Redundanz zur Folge hat. Funktioniert eine der Überwachungseinheiten, ein zugeordneter Sensor, der zugeordnete Abschaltpfad oder ein zugeordneter Aktor zur Abschaltung nicht korrekt, so erfolgt eine Abschaltung durch die andere Überwachungseinheit. Nach Gleichung (1) führt eine Abschaltung der q-Komponente $i_{sq}$ des Statorstromes durch Sperrung der Phasenströmen $i_{su}$, $i_{sv}$, $i_{sw}$ oder eine Abschaltung des Rotorflusses $\psi_p$ durch Sperrung des Erregerstromes $i_p$ zu einem Ist-Drehmoment M = 0 Nm, d.h. zu einer Momentenfreiheit bzw. Abschaltung der Elektromaschine 1.

Auch eine Modulation der Phasenströme $i_{su}$, $i_{sv}$, $i_{sw}$ kann genutzt werden, um Auswirkungen auf magnetische und elektrische Größen im Rotor 3 hervorzurufen und diese zu plausibilisieren. Zu diesem Zweck kann vorteilhaft eine Modulation der d-Komponente $i_{sd}$ des Statorstromes eingesetzt werden. Diese bewirkt eine Induktionsspannung in der Erregerwicklung 2 des Rotors 3, welche bei der Regelung des Erregerstromes $i_p$ berücksichtigt wird. Die Erregerspannung wird so moduliert, dass sie diese Induktionsspannung kompensiert. Die Modulation der Erregerspannung kompensiert im fehlerfreien Fall der Elektromaschine 1 die Modulation der Phasenströme $i_{su}$, $i_{sv}$, $i_{sw}$ in ihrer Wirkung auf den Erregerstrom $i_p$. Verändert sich die Induktionsspannung in Folge eines Fehlers der Elektromaschine 1, so erfolgt diese Kompensation nicht mehr vollständig. Im Erregerstrom $i_p$ zeigt sich die Modulation der Phasenströme. Der Erregerstrom $i_p$ weicht von seinem Sollwert $i_{pSoll}$ ab und verlässt einen Bereich, der um den vorgegebenen zeitlichen Verlauf des Erregerstrom-Sollwertes $i_{pSoll}$ aufgespannt ist. Bei einer Synchronmaschine mit Schenkelpolläufer hängt das erzeugte Ist-Drehmoment M auch von der d-Komponente $i_{sd}$ des Statorstromes ab. In diesem Fall wird eine Modulation der d-Komponente $i_{sd}$ des Statorstromes in ihrer Wirkung auf das erzeugte Ist-Drehmoment M kompensiert, beispielsweise durch eine geeignete entgegen gesetzte Modulation des Rotorflusses $\psi_p$ und/oder der q-Komponente $i_{sq}$ des Statorstromes.

Vorteilhafterweise werden die Blöcke 101 zur Ermittlung des Sollflusses, 102 zur Bestimmung und Regelung des Erregerstromes und die erste Überwachungseinheit zur Überwachung des Rotors im Block 104 in einem ersten Steuergerät berechnet, welches nicht weiter dargestellt ist. Der Block 103 zur Stromregelung des Stators wird mitsamt der zweiten Überwachungseinheit des Stators im Block 105 in einem zweiten Steuergerät berechnet. Zwischen den Steuergeräten werden das Solldrehmoment $M_{Soll}$ und der Rotorfluss-Sollwert $\psi_{pSoll}$ z.B. über ein Bussystem ausgetauscht, welches in Figur 1 durch eine gestrichelte Linie B dargestellt ist. Jedes der beiden Steuergeräte enthält eine Überwachungseinheit und kann die Elektromaschine 1 bei detektiertem Fehlerfall abschalten. Damit lassen sich hohe Sicherheitsanforderungen erfüllen. Die dargestellte Partitionierung der Funktionalitäten ist als Beispiel zu sehen, weshalb andere Aufteilungen auf mehrere Steuergeräte auch möglich sind.

Eine weitere Anwendung der erfindungsgemäßen Modulation durch ein Testsignal besteht in der Kalibrierung von Gebern bzw. der Überprüfung von Gebern im Betrieb. Zum Beispiel kann aus der Modulation des Rotorflusses $\psi_p$ und deren Auswirkung auf die magnetischen und elektrischen Größen im Stator auf den aktuellen Rotordrehwinkel $\vartheta$ geschlossen werden. Dies kann zur Kalibrierung eines Rotordrehwinkelsensors, d.h. zur Herstellung eines Bezuges zwischen dem Signal des Rotordrehwinkelsensors und dem aktuellen elektrischen Rotordrehwinkel, genutzt werden, beispielsweise nach einer Montage des Rotorwinkelsensors oder zu dessen Überprüfung im laufenden Betrieb.

Mit der vorgeschlagenen Modulation lassen sich geberlose Regelverfahren unterstützen, die auf einen Rotordrehwinkelsensor bzw. Rotordrehzahlsensor an der Elektromaschine verzichten. Diese Verfahren funktionieren sonst nur bei höheren Rotordrehzahlen besonders gut. Auch für einen Notbetrieb der Elektromaschine bei einem Ausfall des Rotordrehwinkel- bzw. Rotordrehzahlsensors kann die Modulation eingesetzt werden.

Eine weitere Anwendung der erfindungsgemäßen Modulation durch ein Testsignal besteht in der Adaption von Kennwerten der Elektromaschine 1, beispielsweise von Induktivitäten, Gegeninduktivitäten, und Widerständen, welche für die Regelung wichtig sind. Zum Beispiel kann aus der Modulation des Rotorflusses $\psi_p$ und deren Auswirkung auf die magnetischen und elektrischen Größen im Stator auf die aktuellen magnetischen und elektrischen Eigenschaften der Elektromaschine 1 geschlossen werden.

**Patentansprüche**

1. Verfahren zur Erkennung eines Fehlverhaltens einer Elektromaschine, bei welchem eine erste, das Drehmoment (M) der Elektromaschine (1) beeinflussende Größe ($i_{sq}$) moduliert wird, **dadurch gekennzeichnet, dass** eine zweite, das Drehmoment der Elektromaschine beeinflussenden Größe ($\psi_p$) moduliert wird, wobei sich die beiden, das Drehmoment (M) beeinflussende Größen ($\psi_p$, $i_{sq}$) in ihrer Wirkung auf einen Parameter der Elektromaschine (1), insbesondere ein Drehmoment (M), eine Drehzahl, einen elektrischen Parameter und/oder einen magnetischen Parameter, im fehlerfreien Betrieb kompensieren, während bei einer Nichtkompensation auf einen Fehlerfall geschlossen wird.

2. Verfahren nach Anspruch 1, **dadurch gekennzeichnet, dass** die erste, das Drehmoment (M) beeinflussende Größe ($i_{sq}$) einem Stator der Elektromaschine zugeordnet ist, während die zweite, das Drehmoment (M) beeinflussende Größe ($\psi_p$) einem Rotor (3) der Elektromaschine (1) zugeordnet ist.

3.  Verfahren nach Anspruch 2, **dadurch gekennzeichnet, dass** die dem Stator zugeordnete Größe ein Statorstrom ($i_{sq}$) ist, während die dem Rotor zugeordnete Größe ein Rotorfluss ($\psi_p$) ist.

4.  Verfahren nach Anspruch 1, 2 oder 3, **dadurch gekennzeichnet, dass** die Modulation der ersten und der zweiten, das Drehmoment der Elektromaschine beeinflussenden Größe ($\psi_p$, $i_{sq}$) erfolgt, indem auf das Grundsignal der jeweiligen Größe je ein Testsignal ($\psi_{p\Delta}$) aufmoduliert wird.

5.  Verfahren nach Anspruch 4, **dadurch gekennzeichnet, dass** bei der Aufmodulierung des Testsignals ($\psi_{p\Delta}$) auf das Grundsignal eine Signalbegrenzung berücksichtigt wird, wobei das Testsignal ($\psi_{p\Delta}$) so gewählt wird, dass nach der Aufmodulierung das modulierte Grundsignal die Signalbegrenzung nicht überschreitet.

6.  Verfahren nach Anspruch 4 oder 5, **dadurch gekennzeichnet, dass** mindestens ein Testsignal ($\psi_{p\Delta}$) aus einer Schwingung besteht.

7.  Verfahren nach Anspruch 4, 5 oder 6, **dadurch gekennzeichnet, dass** die Testsignale ($\psi_{p\Delta}$) kontinuierlich auf die erste und die zweite, das Drehmoment (M) der Elektromaschine (1) beeinflussenden Größe ($\psi_p$, $i_{sq}$) aufmoduliert werden.

8.  Verfahren nach Anspruch 4, 5 oder 6, **dadurch gekennzeichnet, dass** die Testsignale ($\psi_{p\Delta}$) in mindestens einem definierten Betriebszustand der Elektromaschine (1) auf die erste und die zweite, das Drehmoment (M) der Elektromaschine (1) beeinflussenden Größe ($\psi_p$, $i_{sq}$) aufmoduliert werden.

9.  Verfahren nach mindestens einem der vorhergehenden Ansprüche, **dadurch gekennzeichnet, dass** die erste und die zweite, das Drehmoment (M) der Elektromaschine (1) beeinflussenden Größen ($\psi_p$, $i_{sq}$) mit Testsignalen ($\psi_{p\Delta}$) moduliert werden, welche ein entgegengesetztes Vorzeichen aufweisen, wodurch sich die Modulationen des ersten und des zweiten, das Drehmoment (M) der Elektromaschine (1) beeinflussenden Größen ($\psi_p$, $i_{sq}$) im fehlerfreien Betrieb der Elektromaschine (1) in ihrer Wirkung auf einen Parameter der Elektromaschine (1), insbesondere ein Drehmoment (M), eine Drehzahl, einen elektrischen Parameter und/oder einen magnetischen Parameter, kompensieren, während der Fehlerfall anhand einer nicht kompensierenden Wirkung auf einen Parameter der Elektromaschine (1), insbesondere ein Drehmoment (M), eine Drehzahl, einen elektrischen Parameter und/oder einen magnetischen Parameter, erkannt wird.

10. Verfahren nach mindestens einem der vorhergehenden Ansprüche, **dadurch gekennzeichnet, dass** nach der Modulation der ersten und der zweiten, das Drehmoment (M) der Elektromaschine (1) beeinflussenden Größe ($\psi_p$, $i_{sq}$) ein Ist-Parameter ($i_{su}$, $i_{sv}$, $i_{sw}$) der Elektromaschine (1) gemessen wird, wobei auf einen fehlerfreien Betrieb der Elektromaschine (1) erkannt wird, wenn dieser Ist-Parameter ($i_{su}$, $i_{sv}$, $i_{sw}$) innerhalb eines Bereiches liegt, welcher um einen vorgegebenen zeitlichen Verlauf eines vorgegebenen Parameters ($i_{suMod}$, $i_{svMod}$, $i_{swMod}$) aufgespannt ist.

11. Verfahren nach Anspruch 2 und 10, **dadurch gekennzeichnet, dass** nach der Modulation der den Rotor (3) der Elektromaschine (1) beeinflussenden Größen ($\psi_p$) ein sich am Stator der Elektromaschine (1) einstellender, erster Ist-Parameter ($i_{su}$, $i_{sv}$, $i_{sw}$) gemessen wird, welcher mit dem Bereich verglichen wird, der um den vorgegebenen zeitlichen Verlauf des vorgegebenen ersten Parameters ($i_{suMod}$, $i_{svMod}$, $i_{swMod}$) aufgespannt ist.

12. Verfahren nach Anspruch 2 und 10, **dadurch gekennzeichnet, dass** nach der Modulation der, den Stator der Elektromaschine (1) beeinflussenden Größen ($i_{su}$, $i_{sv}$, $i_{sw}$) ein sich am Rotor (3) der Elektromaschine (1) einstellender zweiter Ist-Parameter ($i_p$) gemessen wird, welcher mit dem Bereich verglichen wird, der um den vorgegebenen zeitlichen Verlauf des vorgegebenen zweiten Parameters ($i_{pSoll}$) aufgespannt ist.

13. Verfahren nach Anspruch 10, **dadurch gekennzeichnet, dass** nach der Modulation der ersten und der zweiten, das Drehmoment der Elektromaschine (1) beeinflussenden Größe ($\psi_p$, $i_{sq}$) eine, an einem Antriebsstrang eines Kraftfahrzeuges auftretende Drehschwingung gemessen wird und mit einem Bereich verglichen wird, der um den vorgegebenen zeitlichen Verlauf einer vorgegebenen Drehschwingung aufgespannt ist.

14. Verfahren nach Anspruch 10, **dadurch gekennzeichnet, dass** nach der Modulation der ersten und der zweiten, das Drehmoment der Elektromaschine (1) beeinflussenden Größe ($\psi_p$, $i_{sq}$) eine, von der Elektromaschine (1) abgegebene Drehzahl gemessen wird und mit einem Bereich verglichen wird, der um den vorgegebenen zeitlichen Verlauf einer vorgegebenen Drehzahl aufgespannt ist.

**15.** Verfahren nach mindestens einem der Ansprüche 10 bis 14, **dadurch gekennzeichnet, dass** die Überwachung der Drehschwingung, der Drehzahl der Elektromaschine (1), des ersten Ist-Parameters und/oder des zweiten Ist-Parameters getrennt voneinander in jeweils einem Überwachungspfad erfolgt.

**16.** Verfahren nach Anspruch 15, **dadurch gekennzeichnet, dass** zur Überwachung des Fehlverhaltens der Elektromaschine (1) mindestens zwei unabhängige Überwachungspfade, insbesondere gleichzeitig, aktiviert werden.

**17.** Verfahren nach Anspruch 15 oder 16, **dadurch gekennzeichnet, dass** die Überwachungspfade auf mindestens einen gemeinsamen Abschaltpfad der Elektromaschine und/oder einen gemeinsamen Pfad zur Beeinflussung der Funktionsweise der Elektromaschine (1) führen.

**18.** Verfahren nach Anspruch 15 oder 16, **dadurch gekennzeichnet, dass** jeder der Überwachungspfade auf mindestens einen Abschaltpfad der Elektromaschine und/oder einen Pfad zur Beeinflussung der Funktionsweise der Elektromaschine (1) führt.

**19.** Vorrichtung zur Erkennung eines Fehlverhaltens einer Elektromaschine, bei welchem eine erste, das Drehmoment (M) der Elektromaschine (1) beeinflussende Größe ($i_{sq}$) moduliert wird, **dadurch gekennzeichnet, dass** Mittel vorhanden sind, welche eine zweite, das Drehmoment (M) der Elektromaschine (1) beeinflussende Größe ($\psi_p$) modulieren, wobei sich die beiden, das Drehmoment (M) beeinflussenden Größen ($\psi_p$, $i_{sq}$) in ihrer Wirkung auf einen Parameter der Elektromaschine (1), insbesondere ein Drehmoment (M), eine Drehzahl, einen elektrischen Parameter und/oder einen magnetischen Parameter, im fehlerfreien Betrieb kompensieren, während bei einer Nichtkompensation auf einen Fehlerfall geschlossen wird.

**20.** Vorrichtung nach Anspruch 19, **dadurch gekennzeichnet, dass** eine, eine Drehschwingung oder eine Drehzahl oder einen Parameter eines Stators der Elektromaschine oder einen Parameter eines Rotors der Elektromaschine (1) detektierende Überwachungseinheit nur einen Überwachungspfad aufweist, an welchen sich ein Abschaltpfad der Elektromaschine (1) und/oder ein Pfad zur Beeinflussung der Elektromaschine (1) anschließt.

**Claims**

**1.** Method for detecting a malfunction of an electric machine, in which a first variable ($i_{sq}$) influencing the torque (M) of the electric machine (1) is modulated, **characterized in that** a second variable ($\psi_p$) influencing the torque of the electric machine is modulated, wherein, in the event of faultless operation, the two variables ($\psi_p$, $i_{sq}$) influencing the torque (M) compensate for one another in terms of their effect on a parameter of the electric machine (1), in particular a torque (M), a speed, an electric parameter and/or a magnetic parameter, whilst it is concluded that there is a malfunction in the event of the lack of such a compensation.

**2.** Method according to Claim 1, **characterized in that** the first variable ($i_{sq}$) influencing the torque (M) is associated with a stator of the electric machine, whereas the second variable ($\psi_p$) influencing the torque (M) is associated with a rotor (3) of the electric machine (1).

**3.** Method according to Claim 2, **characterized in that** the variable associated with the stator is a stator current ($i_{sq}$), whereas the variable associated with the rotor is a rotor flux ($\psi_p$).

**4.** Method according to Claim 1, 2 or 3, **characterized in that** the first and the second variable ($\psi_p$, $i_{sq}$) influencing the torque of the electric machine are modulated by modulating a test signal ($\psi_{p\Delta}$) to the base signal of the respective variable.

**5.** Method according to Claim 4, **characterized in that** a signal boundary is taken into account during the modulation of the test signal ($\psi_{p\Delta}$) to the base signal, wherein the test signal ($\psi_{p\Delta}$) is selected such that, after modulation, the modulated base signal does not exceed the signal boundary.

**6.** Method according to Claim 4 or 5, **characterized in that** at least one test signal ($\psi_{p\Delta}$) consists of a vibration.

**7.** Method according to Claim 4, 5 or 6, **characterized in that** the test signals ($\psi_{p\Delta}$) are modulated continuously to the first and the second variable ($\psi_p$, $i_{sq}$) influencing the torque (M) of the electric machine (1).

8. Method according to Claim 4, 5 or 6, **characterized in that** the test signals ($\psi_{p\Delta}$) in at least one defined operating state of the electric machine (1) are modulated to the first and the second variable ($\psi_p$, $i_{sq}$) influencing the torque (M) of the electric machine (1).

9. Method as claimed at least in one of the preceding claims, **characterized in that** the first and the second variables ($\psi_p$, $i_{sq}$) influencing the torque (M) of the electric machine (1) are modulated with test signals ($\psi_{p\Delta}$), which have an opposed sign, whereby, in the event of faultless operation of the electric machine (1), the modulations of the first and of the second variables ($\psi_p$, $i_{sq}$) influencing the torque (M) of the electric machine (1) compensate for one another in terms of their effect on a parameter of the electric machine (1), in particular a torque (M), a speed, an electric parameter and/or a magnetic parameter, whilst it is concluded that there is a malfunction on the basis of the lack of such a compensating effect on a parameter of an electric machine (1), in particular a torque (M), a speed, an electric parameter and/or a magnetic parameter.

10. Method as claimed at least in one of the preceding claims, **characterized in that**, after the modulation of the first and of the second variables ($\psi_p$, $i_{sq}$) influencing the torque (M) of the electric machine (1), an actual parameter ($i_{su}$, $i_{sv}$, $i_{sw}$) of the electric machine (1) is measured, wherein it is concluded that there is faultless operation of the electric machine (1) if said actual parameter ($i_{su}$, $i_{sv}$, $i_{sw}$) lies within a range spanned by a predefined course over time of a predefined parameter ($i_{suMod}$, $i_{svMod}$, $i_{swMod}$).

11. Method according to Claim 2 and 10, **characterized in that**, after the modulation of the variables ($\psi_p$) influencing the rotor (3) of the electric machine (1), a first actual parameter ($i_{su}$, $i_{sv}$, $i_{sw}$) occurring at the stator of the electric machine (1) is measured and is compared with the range spanned by the predefined course over time of the predefined first parameter ($i_{suMod}$, $i_{svMod}$, $i_{swMod}$).

12. Method according to Claim 2 and 10, **characterized in that**, after the modulation of the variables ($i_{su}$, $i_{sv}$, $i_{sw}$) influencing the stator of the electric machine (1), a second actual parameter ($i_p$) occurring at the rotor (3) of the electric machine (1) is measured and is compared with the range spanned by the predefined course over time of the predefined second parameter ($i_{pTarget}$).

13. Method according to Claim 10, **characterized in that**, after the modulation of the first and second variable ($\psi_p$, $i_{sq}$) influencing the torque of the electric machine (1), a torsional vibration occurring at a drivetrain of a motor vehicle is measured and is compared with a range spanned by the predefined course over time of a predefined torsional vibration.

14. Method according to Claim 10, **characterized in that**, after the modulation of the first and second variable ($\psi_p$, $i_{sq}$) influencing the torque of the electric machine (1), a speed output by the electric machine (1) is measured and is compared with a range spanned by the predefined course over time of a predefined speed.

15. Method according to at least one of Claims 10 to 14, **characterized in that** the torsional vibration, the speed of the electric machine (1), the first actual parameter and/or the second actual parameter are each monitored separately from one another in a respective monitoring path.

16. Method according to Claim 15, **characterized in that** at least two independent monitoring paths are activated, in particular simultaneously, in order to monitor the malfunction of the electric machine (1).

17. Method according to Claim 15 or 16, **characterized in that** the monitoring paths lead to at least one common switch-off path of the electric machine and/or one common path for influencing the mode of operation of the electric machine (1).

18. Method according to Claim 15 or 16, **characterized in that** each of the monitoring paths leads to at least one switch-off path of the electric machine and/or one path for influencing the mode of operation of the electric machine (1).

19. Device for detecting a malfunction of an electric machine, with which a first variable ($i_{sq}$) influencing the torque (M) of the electric machine (1) is modulated, **characterized in that** means are provided, which modulate a second variable ($\psi_p$) influencing the torque (M) of the electric machine (1), wherein, in the event of faultless operation, the two variables ($\psi_p$, $i_{sq}$) influencing the torque (M) compensate for one another in terms of their effect on a parameter of the electric machine (1), in particular a torque (M), a speed, an electric parameter and/or a magnetic parameter, whilst it is concluded that there is a malfunction in the event of the lack of such a compensation.

**20.** Device according to Claim 19, **characterized in that** a monitoring unit detecting a torsional vibration or a speed or a parameter of a stator of the electric machine or a parameter of a rotor of the electric machine (1) comprises just one monitoring path, which is adjoined by a switch-off path of the electric machine (1) and/or a path for influencing the electric machine (1).

**Revendications**

**1.** Procédé de détection d'un comportement erratique d'une machine électrique, selon lequel une première grandeur ($i_{sq}$) qui influence le couple (M) de la machine électrique (1) est modulée, **caractérisé en ce qu'**une deuxième grandeur ($\psi_p$) qui influence le couple de la machine électrique est modulée, les effets des deux grandeurs ($\psi_p$, $i_{sq}$) qui influencent le couple (M) sur un paramètre de la machine électrique (1), notamment un couple (M), une vitesse de rotation, un paramètre électrique et/ou un paramètre magnétique, se compensant lors du fonctionnement en l'absence de défaut, alors qu'une absence de compensation indique la présence d'un défaut.

**2.** Procédé selon la revendication 1, **caractérisé en ce que** la première grandeur ($i_{sq}$) qui influence le couple (M) est associée à un stator de la machine électrique, alors que la deuxième grandeur ($\psi_p$) qui influence le couple (M) est associée à un rotor (3) de la machine électrique (1).

**3.** Procédé selon la revendication 2, **caractérisé en ce que** la grandeur associée au stator est un courant de stator ($i_{sq}$), alors que la grandeur qui est associée au rotor est un flux de rotor ($\psi_p$).

**4.** Procédé selon la revendication 1, 2 ou 3, **caractérisé en ce que** la modulation des première et deuxième grandeurs ($\psi_p$, $i_{sq}$) qui influencent le couple de la machine électrique est effectuée en surmodulant respectivement un signal de test ($\psi_{p\Delta}$) sur le signal de base de la grandeur correspondante.

**5.** Procédé selon la revendication 4, **caractérisé en ce qu'**une limitation du signal est prise en compte lors de la surmodulation du signal de test ($\psi_{p\Delta}$) sur le signal de base, le signal de test ($\psi_{p\Delta}$) étant choisi de telle sorte qu'après la surmodulation, le signal de base modulé ne dépasse par la limitation du signal.

**6.** Procédé selon la revendication 4 ou 5, **caractérisé en ce qu'**au moins un signal de test ($\psi_{p\Delta}$) se compose d'une oscillation.

**7.** Procédé selon la revendication 4, 5 ou 6, **caractérisé en ce que** le signal de test ($\psi_{p\Delta}$) est surmodulé continuellement sur les première et deuxième grandeurs ($\psi_p$, $i_{sq}$) qui influencent le couple (M) de la machine électrique (1).

**8.** Procédé selon la revendication 4, 5 ou 6, **caractérisé en ce que** le signal de test ($\psi_{p\Delta}$) est surmodulé sur les première et deuxième grandeurs ($\psi_p$, $i_{sq}$) qui influencent le couple (M) de la machine électrique (1) dans au moins un état opérationnel défini de la machine électrique (1).

**9.** Procédé selon au moins l'une des revendications précédentes, **caractérisé en ce que** les première et deuxième grandeurs ($\psi_p$, $i_{sq}$) qui influencent le couple (M) de la machine électrique (1) sont modulées avec des signaux de test ($\psi_{p\Delta}$) qui présentent des signes opposés, de sorte que les effets des modulations des première et deuxième grandeurs ($\psi_p$, $i_{sq}$) qui influencent le couple (M) de la machine électrique (1) sur un paramètre de la machine électrique (1), notamment un couple (M), une vitesse de rotation, un paramètre électrique et/ou un paramètre magnétique, se compensent lors du fonctionnement sans défaut de la machine électrique (1), alors que la présence d'un défaut est détectée au moyen d'un effet non compensateur sur un paramètre de la machine électrique (1), notamment un couple (M), une vitesse de rotation, un paramètre électrique et/ou un paramètre magnétique.

**10.** Procédé selon au moins l'une des revendications précédentes, **caractérisé en ce qu'**après la modulation des première et deuxième grandeurs ($\psi_p$, $i_{sq}$) qui influencent le couple (M) de la machine électrique (1), un paramètre réel ($i_{su}$, $i_{sv}$, $i_{sw}$) de la machine électrique (1) est mesuré, un fonctionnement sans défaut de la machine électrique (1) étant détecté lorsque ce paramètre réel ($i_{su}$, $i_{sv}$, $i_{sw}$) se trouve à l'intérieur d'une plage qui s'étend sur un tracé dans le temps prédéfini d'un paramètre prédéfini ($i_{suMod}$, $i_{svMod}$, $i_{swMod}$).

**11.** Procédé selon les revendications 2 et 10, **caractérisé en ce qu'**après la modulation de la grandeur ($\psi_p$) qui influence le rotor (3) de la machine électrique (1), un premier paramètre réel ($i_{su}$, $i_{sv}$, $i_{sw}$) qui s'établit sur le stator de la machine électrique (1) est mesuré, lequel est comparé avec la plage qui s'étend sur le tracé dans le temps prédéfini du premier paramètre prédéfini ($i_{suMod}$, $i_{svMod}$, $i_{swMod}$).

**12.** Procédé selon les revendications 2 et 10, **caractérisé en ce qu'**après la modulation des grandeurs ($i_{su}$, $i_{sv}$, $i_{sw}$) qui influencent le stator de la machine électrique (1), un deuxième paramètre réel ($i_p$) qui s'établit sur le rotor (3) de la machine électrique (1) est mesuré, lequel est comparé avec la plage qui s'étend sur le tracé dans le temps prédéfini du deuxième paramètre prédéfini ($i_{pSoll}$).

**13.** Procédé selon la revendication 10, **caractérisé en ce qu'**après la modulation des première et deuxième grandeurs ($\psi_p$, $i_{sq}$) qui influencent le couple de la machine électrique (1), une oscillation tournante qui se produit sur une chaîne cinématique d'un véhicule automobile est mesurée et comparée avec une plage qui s'étend sur le tracé dans le temps prédéfini d'une oscillation tournante prédéfinie.

**14.** Procédé selon la revendication 10, **caractérisé en ce qu'**après la modulation des première et deuxième grandeurs ($\psi_p$, $i_{sq}$) qui influencent le couple de la machine électrique (1), une vitesse de rotation délivrée par la machine électrique (1) est mesurée et comparée avec une plage qui s'étend sur le tracé dans le temps prédéfini d'une vitesse de rotation prédéfinie.

**15.** Procédé selon au moins l'une des revendications 10 à 14, **caractérisé en ce que** la surveillance de l'oscillation tournante, de la vitesse de rotation de la machine électrique (1), du premier paramètre réel et/ou du deuxième paramètre réel s'effectue séparément des autres respectivement dans un chemin de surveillance.

**16.** Procédé selon la revendication 15, **caractérisé en ce que**, pour surveiller le comportement erratique de la machine électrique (1), au moins deux chemins de surveillance indépendants sont activés, notamment simultanément.

**17.** Procédé selon la revendication 15 ou 16, **caractérisé en ce que** les chemins de surveillance mènent à au moins un chemin de déconnexion commun de la machine électrique et/ou à un chemin commun destiné à influencer le régime de fonctionnement de la machine électrique (1).

**18.** Procédé selon la revendication 15 ou 16, **caractérisé en ce que** chacun des chemins de surveillance mène à au moins un chemin de déconnexion de la machine électrique et/ou à un chemin destiné à influencer le régime de fonctionnement de la machine électrique (1).

**19.** Dispositif de détection d'un comportement erratique d'une machine électrique, avec lequel une première grandeur ($i_{sq}$) qui influence le couple (M) de la machine électrique (1) est modulée, **caractérisé en ce qu'**il existe des moyens qui modulent une deuxième grandeur ($\psi_p$) qui influence le couple (M) de la machine électrique (1), les effets des deux grandeurs ($\psi_p$, $i_{sq}$) qui influencent le couple (M) sur un paramètre de la machine électrique (1), notamment un couple (M), une vitesse de rotation, un paramètre électrique et/ou un paramètre magnétique, se compensant lors du fonctionnement en l'absence de défaut, alors qu'une absence de compensation indique la présence d'un défaut.

**20.** Dispositif selon la revendication 19, **caractérisé en ce qu'**une unité de surveillance qui détecte une oscillation tournante ou une vitesse de rotation ou un paramètre d'un stator de la machine électrique ou un paramètre d'un rotor de la machine électrique (1) ne présente qu'un seul chemin de surveillance auquel se rattache un chemin de déconnexion de la machine électrique (1) et/ou un chemin destiné à influencer la machine électrique (1).

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1387459 A1
- US 2010320953 A1

- EP 2226929 A1